# EUROPÄISCHE PATENTSCHRIFT

(11) **EP 2 625 933 B1**
(45) Veröffentlichungstag und Bekanntmachung des Hinweises auf die Patenterteilung: **28.01.2015**
(21) Anmeldenummer: 11779108.7
(22) Anmeldetag: 20.09.2011
(51) Int. Cl.: H05H 9/00, H05H 7/02, H05H 7/18

(54) **HF-VORRICHTUNG UND BESCHLEUNIGER MIT EINER SOLCHEN HF-VORRICHTUNG**
HF APPARATUS AND ACCELERATOR HAVING SUCH AN HF APPARATUS
DISPOSITIF HF ET ACCÉLÉRATEUR DOTÉ D'UN TEL DISPOSITIF HF

(30) Priorität: 07.10.2010 DE 102010042149
(43) Veröffentlichungstag der Anmeldung: 14.08.2013
(73) Patentinhaber: Siemens Aktiengesellschaft, 80333 München (DE)
(72) Erfinder: HEID, Oliver, 91052 Erlangen (DE); HUGHES, Timothy, 91056 Erlangen (DE)
(86) Internationale Anmeldenummer: PCT/EP2011/066265
(87) Internationale Veröffentlichungsnummer: WO 2012/045571

(56) Entgegenhaltungen:
- WO-A1-2011/061026
- US-A- 3 495 125
- US-A- 3 546 633
- US-A- 4 066 988
- HEID O ET AL: "Compact Solid State Direct drive RF Linac", PROCEEDINGS OF IPAC (2010) KYOTO, JAPAN, , 23. Mai 2010 (2010-05-23), Seiten 4278-4280, XP002658698, ISBN: 978-92-9083-352-9 Gefunden im Internet: URL:http://accelconf.web.cern.ch/AccelConf /IPAC10/papers/thpd002.pdf [gefunden am 2011-09-08]

## Beschreibung

Die Erfindung betrifft eine HF-Vorrichtung mit einer von einer Außenwand begrenzten HF-Kavität und einer an der Außenwand angeordneten und einen HF-Generator sowie eine Abschirmung aufweisenden Einkopplungseinrichtung. Der HF-Generator koppelt dabei über einen in der Außenwand ausgebildeten Spalt ein elektromagnetisches Feld in das Innere der HF-Kavität ein. Die Abschirmung ist dabei resonant ausgebildet und weist bei der Generator-Frequenz eine hohe Impedanz auf. Ferner betrifft die Erfindung einen Teilchenbeschleuniger mit wenigstens einer solchen HF-Vorrichtung.

Bei HF-Kavitäten, die als Resonatoren für eine hochfrequente elektromagnetische Felder dienen, handelt es sich typischerweise um Hohlkörper mit einer elektrisch leitenden Außenwand. Ein außerhalb der Kavität angeordneter HF-Generator erzeugt eine elektromagnetische Strahlung hoher Frequenz, die über eine Öffnung in der Außenwand der Kavität in das Innere der Kavität eingekoppelt wird. Durch die vom Generator erzeugten elektromagnetischen Wechselfelder werden u. a. Wechselströme induziert, die sich entlang an der Innenseite der Außenwand vorhandener Strompfade fortpflanzen. Abhängig von der Generator-Frequenz und den Welleneigenschaften der Kavität können im Inneren der HF-Kavität verschiedene Resonanzmoden auftreten. Allerdings werden durch die Anordnung des HF-Generators außerhalb der Kavität auch Ströme an der Außenseite der Außenwand induziert, durch die die in die Kavität eingekoppelte Leistung und damit die Effizienz der Kavität reduziert werden kann.

In der Veröffentlichung von O. Heid et al.: "Compact Solid State Direct drive RF Linac" in den Proceedings of IPAC (2010) Kyoto, Japan, 23. Mai 2010, S. 4278-4280 wird ein Ansteuerungskonzept für einen RF-Beschleuniger vorgestellt, bei dem eine verteilte Festkörper-RF-Quelle in den RF-Resonator des Beschleunigers integriert ist.

Es ist daher Aufgabe der Erfindung, eine möglichst effektive Einkopplung der HF-Strahlung in die HF-Kavität zu erreichen. Diese Aufgabe wird durch eine HF-Vorrichtung nach Anspruch 1 sowie einen Teilchenbeschleuniger nach Anspruch 11 erreicht. Weitere vorteilhafte Ausführungsformen der Erfindung sind in den untergeordneten Ansprüchen angegeben.

Gemäß der Erfindung ist eine HF-Vorrichtung umfassend eine HF-Resonanzeinrichtung mit einer elektrisch leitenden Außenwand vorgesehen, wobei die Außenwand einen sich entlang ihres Umfangs erstreckenden Spalt umfasst. Die HF-Vorrichtung umfasst ferner eine Einkopplungseinrichtung mit einem an der Außenseite der Außenwand der HF-Resonanzeinrichtung im Bereich des Spalts angeordneten HF-Generator zum Einkoppeln einer HF-Strahlung einer bestimmten Frequenz über den Spalt in das Innere der HF-Resonanzeinrichtung und mit einer den Generator nach außen abschirmenden und den Spalt an der Außenseite der Außenwand elektrisch überbrückenden Abschirmung. Die Abschirmung ist dabei als ein Resonator mit einer hohen Impedanz für die Frequenz des Generators ausgebildet. Die HF-Resonanzeinrichtung (110) ist als eine koaxiale leitende Verbindung ausgebildet. Solche koaxialen Wellenleiter können besonders flexibel eingesetzt werden. Die hohe Impedanz bewirkt, dass weniger Strom über die Abschirmung fließt. Die Ausbildung der Abschirmung in Form eines Resonators ermöglicht dabei auf eine besonders einfache Weise hohe Impedanzen und damit eine sehr effiziente Einkopplung der HF-Strahlung in die Resonanzeinrichtung. Da durch die Abschirmung keine RF-Ströme auf der Kavitätsaußenseite auftreten, ist die der Umgang mit der HF-Vorrichtung insgesamt sicherer. Ferner lässt sich eine auf Massepotential gehaltene HF-Kavität verträglicher mit anderen Vorrichtungen kombinieren.

Eine Ausführungsform sieht vor, dass die resonant ausgebildete Abschirmung auf eine von der Generator-Frequenz abweichende Resonanzfrequenz abgestimmt ist. Hierdurch kann der Wellenleitungswiderstand und damit das Verhalten der resonanten Abschirmung im Betrieb je nach Anwendung beliebig eingestellt werden.

Eine weitere Ausführungsform sieht vor, dass die Abschirmung auf eine Resonanzfrequenz oberhalb der Generator-Frequenz abgestimmt ist. Hierdurch wird wirkungsvoll verhindert, dass bei der Generator-Frequenz in der als Resonator ausgebildeten Abschirmung ein Resonanzmode mit geringer Impedanz entsteht.

Gemäß einer weiteren Ausführungsform ist vorgesehen, dass die kapazitiven und die induktiven Eigenschaften der Abschirmung derart abgestimmt sind, dass sich in der Abschirmung bei der Generator-Frequenz eine stehende elektromagnetische Welle mit einem Stromknoten im Bereich des Spalts ausbildet. Hiermit wird eine möglichst hohe eingangsseitige Impedanz der Abschirmung erreicht.

In einer weiteren Ausführungsform ist vorgesehen, dass die elektrische Leitungslänge der Abschirmung im Wesentlichen einem Viertel der Wellenlänge der vom Generator erzeugten elektromagnetischen Welle entspricht. Diese Leitungslänge stellt eine besonders günstige Ausführungsform dar, da sich die Abstimmung der Abschirmung in diesem Fall am einfachsten gestaltet.

Ein weiteres Beispiel sieht vor, dass die HF-Resonanz-einrichtung als eine HF-Kavität ausgebildet ist. HF-Kavitäten eignen sich aufgrund ihrer hohen Güte besonders gut zur Erzeugung resonanter elektromagnetischer Wellen.

In einer weiteren Ausführungsform ist vorgesehen, dass der Generator mehrere entlang des Umfangs der HF-Resonanzeinrichtung verteilt angeordnete Transistormodule umfasst. Mithilfe solcher Transistormodule können elektromagnetische Felder direkt an der Resonanzeinrichtung erzeugt werden. Dies ermöglicht eine besonders effektive Einkopplung elektromagnetischer Strahlung.

In einer weiteren Ausführungsform ist vorgesehen, dass der Spalt von zwei sich gegenüberliegenden Flanschen der Außenwand der HF-Resonanzeinrichtung begrenzt wird, wobei die Transistormodule jeweils in Aussparungen innerhalb der beiden Flansche angeordnet sind. Diese spezielle Anordnung der Trarisistormodule erlaubt eine besonders effektive Einkopplung von Wechselströmen in die Resonanzeinrichtung.

Erfindungsgemäß ist ferner ein Teilchenbeschleuniger mit wenigstens einer entsprechenden HF-Vorrichtung vorgesehen. Mithilfe eines solchen Teilchenbeschleunigers lassen sich besonders starke elektromagnetische Felder erzeugen.

In einer Ausführungsform ist vorgesehen, dass der Teilchenbeschleuniger mehrere hintereinander geschaltete HF-Kavitäten umfasst. Durch die Zusammenschaltung der HF-Kavitäten kann die Stärke der erzeugten elektromagnetischen Felder besonders einfach erhöht werden.

Die Erfindung wird im Folgenden anhand von Figuren näher beschrieben. Es zeigen:
- Figuren 1 und 2: schematisch eine zylinderförmige HF-Kavität mit einer entlang ihres Umfangs angeordneten Einkopplungseinrichtung zur Einkopplung von HF-Strahlung in die HF-Kavität,
- Figur 3: einen Längsschnitt durch die HF-Kavität aus Figur 1 mit detaillierter Darstellung der Einkopplungseinrichtung,
- Figur 4: einen Querschnitt durch die in der Figur 3 gezeigte HF-Vorrichtung entlang der Linie IV-IV,
- Figur 5: eine vereinfachte Modelldarstellung der für die HF-Strahlung als Wellenleiter dienenden Abschirmung,
- Figur 6: ein Stromverteilungsdiagramm zur Verdeutlichung der entlang der als λ/4 Wellenleitung ausgebildeten Abschirmung auftretenden Stromstärken mit einem im Bereich des Spalts liegenden Stromknoten,
- Figur 7: eine HF-vorrichtung mit einer als koaxiale Leitung ausgebildeten HF-Resonanzeinrichtung, und
- Figur 8: einen durch Zusammenschaltung mehrerer HF-Kavitäten erzeugten Teilchenbeschleuniger.

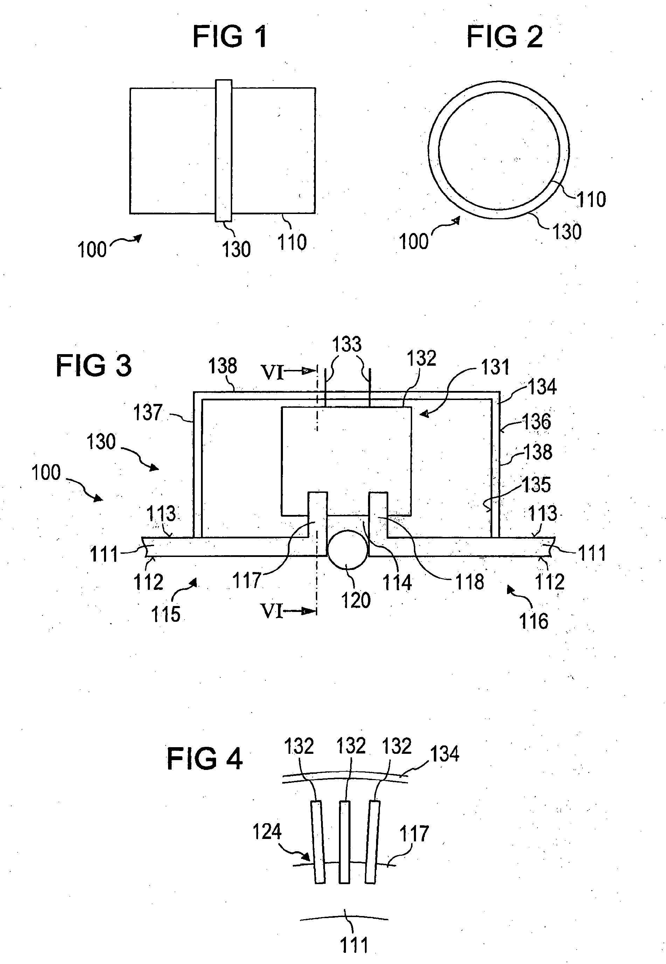

Figur 1 zeigt eine Seitenansicht einer erfindungsgemäßen HF-Vorrichtung 100. Die Vorrichtung 100 umfasst dabei eine zylindrische HF-Kavität 110 mit einer metallischen Außenwand, die als Resonanzeinrichtung für eine HF-Strahlung einer bestimmten Frequenz dient. Entlang des Umfangs der HF-Kavität 110 ist eine Einkopplungseinrichtung 130 zum Einkoppeln von HF-Leistung in die HF-Kavität 110 angeordnet.

In Figur 2 ist die HF-Vorrichtung 100 aus Figur 1 in einer Frontansicht dargestellt. Hierbei wird deutlich, dass die Einkopplungseinrichtung 130 sich entlang des gesamten Umfangs der HF-Kavität 110 erstreckt. Je nach Anwendung kann sich die Einkopplungseinrichtung 130 auch nur über einen Teil des Umfangs der HF-Kavität 110 erstrecken. Ferner können auch mehrere solcher sich nur über einen Teil des Umfangs, d.h. lediglich abschnittsweise, erstreckende Einkopplungseinrichtungen 130 entlang des Umfangs der HF-Kavität 110 angeordnet sein.

Die Einkopplungseinrichtung 130 wird im Folgenden anhand von Querschnitten näher erläutert. Hierzu zeigt die Figur 3 einen Längsschnitt und die Figur 4 einen Querschnitt der in der Figur 1 gezeigten erfindungsgemäßen HF-Vorrichtung 100.

Wie in Figur 3 gezeigt ist, weist die metallische Außenwand 111 der HF-Kavität 110 im Bereich der Einkopplungseinrichtung 130 einen sich entlang des Umfangs der HF-Kavität 110 erstreckenden Spalt 114 auf. Der Spalt 114 unterteilt die Außenwand 111 im folgenden Beispiel in einen ersten und einen zweiten Wandabschnitt 115, 116. Innerhalb des Spalts 114 ist ein Isolierring 120 aus einem nicht elektrisch leitfähigen Material angeordnet. Die ringförmige Isolierung 120 kann auch gleichzeitig eine Vakuumdichtung bilden. Die Enden der beiden Wandabschnitte 115, 116 sind jeweils in Form eines Flansches 117, 118 ausgebildet.

Die an der Außenseite 113 der Kavitätsaußenwand 111 angeordnete Einkopplungseinrichtung 130 umfasst einen im Bereich des Spalts 114 angeordneten Generator 131 sowie eine dem Generator komplett umhüllende metallische Abschirmung 134. Der zur Erzeugung einer HF-Strahlung einer bestimmten Frequenz f_{G} ausgebildete Generator 131 umfasst dabei vorzugsweise mehrere entlang des Umfangs verteilt angeordnete Transistormodule 132. Die einzelnen Transistormodule 132 sind dabei in speziellen Aussparungen in den beiden Flanschen 117, 118 angeordnet und stehen daher in direktem Kontakt mit den der Außenwand 111. Diese Anordnung erlaubt eine höhere HF-Leistung, da einerseits die Fläche zur Einkopplung der HF-Strahlung relativ groß ist und andererseits die Erzeugung der HF-Strahlung direkt dort stattfindet, wo die Leistung benötigt wird.

Wie in der Figur 3 gezeigt ist, sind die Transistormodule 132 über Verbindungsleitungen 133 mit einer hier nicht dargestellten DC-Stromquelle bzw. Steuereinrichtung verbunden. Bei einer Aktivierung erzeugen die Festkörper-Transistoren der Module 132 elektromagnetische Wechselfelder, welche wiederum sich entlang der Außenwand 111 ausbreitende Wechselströme induzieren. Aufgrund der hohen Frequenz treten die Wechselströme dabei lediglich in relativ dünnen Randschichten auf der Innen- und der Außenseite der metallischen Außenwand 111 auf. Um zu erreichen, dass so viel wie möglich der induzierten Wechselströme sich entlang der Innenseite 112 der HF-Kavität 110 ausbreiten, ist vorgesehen, die Impedanz des RF-Pfads an der Außenseite 113 der Kavität 110 möglichst hoch auszubilden. Dies wird durch die speziell ausgebildete Abschirmung 134 sowie den Spalt 114, der eine hohe Impedanz bei der Resonanzfrequenz der HF-Kavität 110 bildet, erreicht. Bspw. bewirkt die Verwendung einer gerippten Abschirmung eine hohe Impedanz des RF-Pfads an der Außenseite 113 der Kavität 110, so dass die Ströme gezwungen sind, an der Innenseite zu fließen.

Um eine Ausbreitung der HF-Ströme entlang der Außenseite 113 der Außenwand 111 zu unterbinden, ist die Abschirmung 134 elektrisch mit der Außenwand 111 verbunden. Wie in Figur 3 dargestellt ist, überbrückt die metallische Abschirmung 134 den Spalt 114 dabei elektrisch und stellt so einen Kurzschluss zwischen den beiden Wandabschnitten 115, 116 dar. Da die induzierten Wechselströme sich nur den Randschicht der Außenwand 111 auftreten, während der Innenbereich der metallischen Außenwand 111 im Wesentlichen strom- und feldfrei ist, wird durch den mittels der Abschirmung erzeugten Kurzschluss lediglich der sich entlang der Außenseite 113 der Kavitätsaußenwand 111 ausbreitende Wechselstrom beeinflusst. So breiten sich die an der Außenseite 113 der Kavitätsaußenwand 111 induzierten Ströme entlang der Innenseite 135 der die Abschirmung 134 bildenden Bleche 136, 137, 138 aus, während die Kavitätsaußenwand 111 außerhalb der Abschirmung 134 praktisch strom- bzw. spannungslos ist. Um die Einkopplung der HF-Ströme in das Innere der HF-Kavität 110 zu optimieren, ist die Abschirmung 134 resonant ausbildet. Hierzu werden die Wellenleitungseigenschaften der Einkopplungseinrichtung 130 so abgestimmt, dass sich für die im Inneren der Abschirmung 134 ausbreitenden Wechselströme im Bereich des Spalts 114 eine möglichst hohe Impedanz ergibt.

Figur 4 zeigt einen Querschnitt durch die in Figur 3 gezeigte HF-Kavität 100 entlang der Linie IV-IV. Hieraus wird ersichtlich, dass die entlang des Umfangs der Außenwand 111 der Kavität 110 angeordneten Transistormodule 132 in entsprechenden Aussparungen der Flansche 117, 118 untergebracht sind.

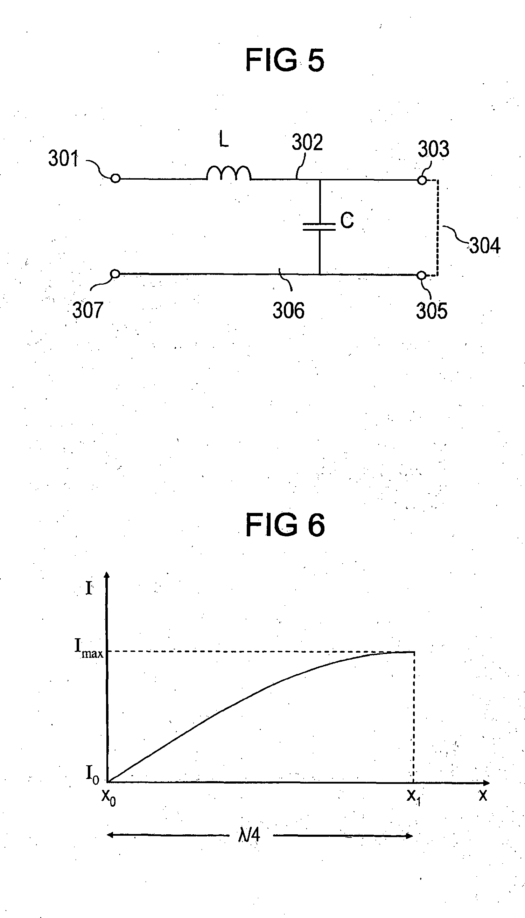

Figur 5 zeigt ein stark vereinfachtes Ersatzschaltbild der Abschirmung 134. Dabei wird die Abschirmung 134 als eine kurzgeschlossene Wellenleitung betrachtet. In diesem Fall entsprechen die beiden linken Anschlüsse 131, 137 den Einspeisepunkte der HF-Strahlung im Bereich des Spalts. Die beiden oberen und unteren Leitungsabschnitte 302, 306 entsprechen hingegen den beiden im Wesentlichen symmetrischen Strompfade der hier betrachteten Wechselströme entlang der Innenseite 135 der Abschirmung 134. Dabei wird der obere Leitungsabschnitt 302 im Wesentlichen durch die linke Seitenwand 136 der Abschirmung 134, dem innerhalb der Abschirmung 134 angeordneten Teil des ersten Außenwandabschnitts 115 sowie einem Teil der oberen Deckenwand 137 der Abschirmung gebildet. Analog hierzu wird der untere Leitungsabschnitt 306 in dem hier gezeigten Ersatzschaltbild 300 durch die rechte Seitenwand 136 der Abschirmung 134, den innerhalb der Abschirmung 134 angeordneten Teil des zweiten Außenwandabschnitts 116 sowie einen Teil der oberen Deckenwand 137 der Abschirmung 134 gebildet. Die Kapazität C wird im Wesentlichen durch die kapazitiven Eigenschaften der Einkoppelvorrichtung 130 bestimmt, die sowohl von der Geometrie der beispielsweise aus Kupfer gebildeten Abschirmung 134 als auch von den Materialeigenschaften des von der Abschirmung 134 eingeschlossenen Raumvolumens abhängen. Hingegen hängt die im Ersatzschaltbild gezeigte Induktivität L unter anderem von der elektrischen Leitungslänge ab, die wiederum von verschiedenen Faktoren, wie z. B. der geometrischen Leitungslänge abhängt. Die Gesamtinduktivität wird dabei durch die Induktivitäten der einzelnen Abschnitte der vom Strom zurückgelegten Wegstrecke bestimmt. Wie in der Figur 5 ferner mittels der gestrichelten Linie 304 angedeutet ist, ist die hier dargestellte Ersatzschaltung 300 ausgangsseitig kurzgeschlossen, da die beiden im folgenden Fall symmetrischen Leitungsstränge über das Deckenelement 138 der Abschirmung 134 elektrisch miteinander verbunden sind. Dabei bestimmt das Verhältnis der elektrischen Leitungslänge der kurzgeschlossenen Leitung zur Wellenlänge λ der vom Generator 131 erzeugten HF-Strahlung, ob sich die U-förmige Leitung wie eine Kapazität, eine Induktivität oder ein Schwingkreis verhält. In dem Spezialfall, dass die elektrische Leitungslänge ein Viertel der Wellenlänge λ der sich an der Innenseite der Abschirmung 134 fortpflanzenden Stromwellen beträgt, bildet die Schaltung einen Parallel-Schwingkreis mit den Resonanzwellenlängen λ, λ/3, λ/5 usw. Bei einer entsprechend auf ein Viertel der Wellenlänge λ abgestimmten Abschirmung 134 stellt sich für den Stromanteil der elektromagnetischen Welle somit ein Stromknoten im Bereich des Spalts 114 ein. Im Resonanzfall geht die Eingangsimpedanz des von der Abschirmung gebildeten Resonanzkreises gegen unendlich, so dass die vom Generator dissipierte HF-Leistung fast vollständig in die eine möglichst niedrige Impedanz aufweisende HF-Kavität eingekoppelt wird. Die Leitungslänge der Abschirmung muss jedoch nicht optimal auf λ/4 abgestimmt sein. Ja nach Anwendung kann es bereits genügen, wenn die Eingangsimpedanz des von der Abschirmung gebildeten Schwingkreises deutlich höher als die Eingangsimpedanz der HF-Kavität ausfällt. Auch in diesem Fall wird sich der induzierte Strom vorwiegend auf der Innenseite 112 der Auenwand 111 ausbreiten. Somit kann eine optimale Einkopplung HF-Leistung in die HF-Kavität erzielt werden.

Die Figur 6 zeigt zur Verdeutlichung den Stromverlauf entlang der durch die Abschirmung 134 gebildeten λ/4-Leitung. Hierbei wird ersichtlich, dass die Stromstärke sinusförmig verläuft mit einem Minimum am Eingang (x₀) und einem Maximum am Ende (x₁) der Leitung.

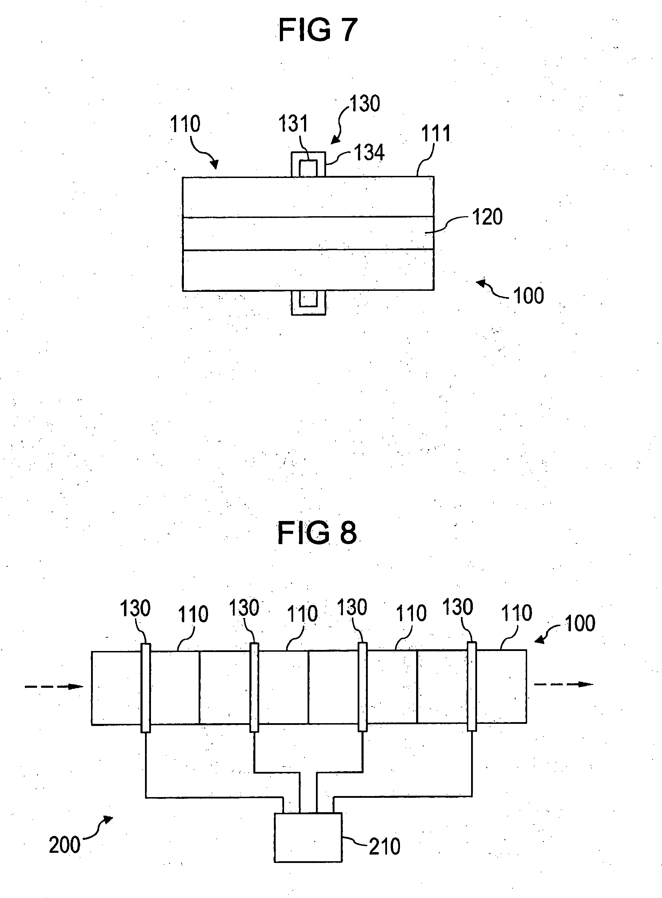

Das hier gezeigte erfindungsgemäße Konzept kann grundsätzlich auf alle HF-Kavitäten sowie auf andere resonante Wellenleiterstrukturen, wie z.B. auf eine koaxiale Leitung oder eine Re-Entrant-Cavity, übertragen werden. So zeigt die Figur 7 eine HF-Vorrichtung, bei der die zuvor in Zusammenhang mit einer HF-Kavität gezeigte Einkopplungseinrichtung 130 zum Einkoppeln von elektrischer Energie an einer koaxial leitenden Verbindung verwendet wird. Wie in der Figur 7 gezeigt ist, erstreckt sich der Generator 131 sowie die den Generator umgebende Abschirmung 134 entlang des Außenumfangs des Außenleiters 111 der koaxialen Verbindung 110. In der hier gezeigten Schnittdarstellung ist ebenfalls der für koaxiale Verbindungen typische Innenleiter 120 gezeigt.

Um höhere HF-Leistungen zu erreichen, lassen sich mehrere der in den Figuren 1 bis 4 gezeigten HF-Kavitäten hintereinander schalten. Die Figur 8 zeigt hierzu eine Hintereinanderschaltung von insgesamt vier HF-Kavitäten 100. Die so gebildete Anordnung 200 dient im folgenden Ausführungsbeispiel als Teilchenbeschleuniger. Die einzelnen Kavitäten 110 lassen sich dabei separat ansteuern. Hierzu sind die Einkopplungseinrichtungen 130 der vier HF-Kavitäten 100 über separate Leitungen an eine gemeinsame Steuer- bzw. Spannungsversorgungseinrichtung 210 gekoppelt. Da die Wandströme sich nur entlang der Innenseite der Kavitätswände ausbreiten können, sind die miteinander zusammen geschalteten Kavitäten 110 an der Außenseite RF-technisch voneinander entkoppelt. Daher können sie trotz der DC-Verbindung unabhängig voneinander gesteuert werden.

Die Erfindung ist nicht nur auf die hier beispielhaft gezeigten Ausführungen eingeschränkt. Vielmehr lässt sich das erfindungsgemäße Konzept auf jede geeignete RF-Struktur anwenden, bei der Wandströme in das Innere eingekoppelt und nach außen hin abgeschirmt werden sollen.

## Patentansprüche

1. HF-Vorrichtung (100) umfassend:
- eine HF-Resonanzeinrichtung (110) mit einer elektrisch leitenden Außenwand (111), wobei die Außenwand (111) einen sich entlang ihres Umfangs erstreckenden Spalt (114) umfasst, und
- eine Einkopplungseinrichtung (130) mit
einem an der Außenseite (113) der Außenwand (111) der HF-Resonanzeinrichtung (110) im Bereich des Spalts (114) angeordneten HF-Generator (131) zum Einkoppeln einer HF-Strahlung einer bestimmten Generator-Frequenz (f_{G}) über den Spalt (114) in das Innere der HF-Resonanzeinrichtung (110), und
einer den Generator (131) nach außen abschirmenden und den Spalt (114) an der Außenseite (113) der Außenwand (111) elektrisch überbrückenden Abschirmung (134),
wobei die Abschirmung (134) als ein Resonator mit einer hohen Impedanz für die Generator-Frequenz (f_{G}) ausgebildet ist, **dadurch gekennzeichnet, dass** die HF-Resonanzeinrichtung (110) als eine koaxiale leitende Verbindung ausgebildet ist.

2. HF-Vorrichtung (100) nach Anspruch 1,
wobei die Abschirmung (134) auf eine von der Generator-Frequenz (f_{G}) abweichende Resonanzfrequenz (f_{R}) abgestimmt ist.

3. HF-Vorrichtung (100) nach Anspruch 1 oder 2,
wobei die Abschirmung (134) auf eine Resonanzfrequenz (f_{A}) oberhalb der Generator-Frequenz (f_{G}) abgestimmt ist.

4. HF-Vorrichtung nach einem der vorhergehenden Ansprüche,
wobei die kapazitiven und induktiven Eigenschaften der Abschirmung (134) derart abgestimmt sind, dass sich bei der Generator-Frequenz (f_{G}) in der Abschirmung (134) eine stehende elektromagnetische Welle mit einem Stromknoten im Bereich des Spalts (114) ausbildet.

5. HF-Vorrichtung (100) nach einem der vorhergehenden Ansprüche,
wobei die elektrische Leitungslänge der Abschirmung (134) im Wesentlichen einem Viertel der Wellenlänge λ der vom Generator erzeugten elektromagnetischen Welle entspricht.

6. HF-Vorrichtung nach einem der Ansprüche 1 bis 5,
wobei die HF-Resonanzeinrichtung (110) als ein Wellenleiter ausgebildet ist.

7. HF-Vorrichtung nach einem der vorhergehenden Ansprüche,
wobei der Generator (131) mehrere entlang des Umfangs der HF-Resonanzeinrichtung (110) verteilt angeordnete Transistormodule (132) umfasst.

8. HF-Vorrichtung nach Anspruch 7,
wobei der Spalt von zwei sich gegenüberliegenden Flanschen (117, 118) der Außenwand (111) der HF-Resonanzeinrichtung (110) begrenzt wird, und
wobei die Transistormodule (132) jeweils in Aussparungen (124) innerhalb der beiden Flansche (117, 118) angeordnet sind.

9. Teilchenbeschleuniger (200) mit wenigstens einer HF-Vorrichtung (100) nach einem der Ansprüche 1 bis 8.

10. Teilchenbeschleuniger (200) nach Anspruch 9,
wobei der Teilchenbeschleuniger (200) weinigstens zwei hintereinander geschaltete HF-Kavitäten (100) umfasst.

## Claims

1. RF apparatus (100) comprising:
- an RF resonance device (110) having an electrically conductive outer wall (111), the outer wall (111) comprising a gap (114) extending over its circumference, and
- an input coupling device (130) having
an RF generator (131), arranged on the outer side (113) of the outer wall (111) of the RF resonance device (110) in the region of the gap (114), for coupling RF radiation of a particular generator frequency (f_{G}) through the gap (114) into the interior of the RF resonance device (110), and
shielding (134) which externally shields the generator (131) and electrically bridges the gap (114) on the outer side (113) of the outer wall (111),
wherein the shielding (134) is formed as a resonator with a high impedance for the generator frequency (f_{G}),
**characterized in that** the RF resonance device (110) is formed as a coaxial conductive connection.

2. RF apparatus (100) according to Claim 1, wherein the shielding (134) is tuned to a resonant frequency (f_{R}) different to the generator frequency (f_{G}).

3. RF apparatus (100) according to Claim 1 or 2, wherein the shielding (134) is tuned to a resonant frequency (f_{A}) above the generator frequency (f_{G}).

4. RF apparatus according to one of the preceding claims, wherein the capacitive and inductive properties of the shielding (134) are adapted so that a standing electromagnetic wave having a current node in the region of the gap (114) is formed in the shielding (134) at the generator frequency (f_{G}).

5. RF apparatus (100) according to one of the preceding claims, wherein the electrical length of the shielding (134) corresponds essentially to one fourth of the wavelength λ of the electromagnetic wave generated by the generator.

6. RF apparatus according to one of Claims 1 to 5, wherein the RF resonance device (110) is formed as a waveguide.

7. RF apparatus according to one of the preceding claims, wherein the generator (131) comprises a plurality of transistor modules (132) distributed over the circumference of the RF resonance device (110).

8. RF apparatus according to Claim 7, wherein the gap is delimited by two opposite flanges (117, 118) of the outer wall (111) of the RF resonance device (110), and wherein the transistor modules (132) are respectively arranged in recesses (124) inside the two flanges (117, 118).

9. Particle accelerator (200) comprising at least one RF apparatus (100) according to one of Claims 1 to 8.

10. Particle accelerator (200) according to Claim 9, wherein the particle accelerator (200) comprises at least two RF cavities (100) connected in series.

## Revendications

1. Dispositif HF (100), comprenant :
un dispositif résonant HF (110) présentant une paroi extérieure (111) électroconductrice, la paroi extérieure (111) comportant une fente (114) s'étendant le long de sa périphérie ,et
un dispositif d'injection (130) comprenant un générateur HF (131), agencé sur le côté extérieur (113) de la paroi extérieure (111) du dispositif résonant HF (110) au niveau de la fente (114) et servant à injecter un rayonnement HF d'une fréquence de générateur (f_{G}) définie à l'intérieur du dispositif résonant HF (110) par l'intermédiaire de la fente (114), et
un blindage (134) assurant un blindage du générateur (131) vers l'extérieur et un pontage électrique de la fente (114) sur le côté extérieur (113) de la paroi extérieure (111),
le blindage (134) étant exécuté en tant que résonateur présentant une impédance élevée à la fréquence de générateur (f_{G}),
**caractérisé en ce que** le dispositif résonant HF (110) est exécuté en tant que liaison conductrice coaxiale.

2. Dispositif HF (100) selon la revendication 1, le blindage (134) étant accordé à une fréquence de résonance (f_{R}) différente de la fréquence de générateur (f_{G}).

3. Dispositif HF (100) selon la revendication 1 ou 2, le blindage (134) étant accordé à une fréquence de résonance (f_{A}) au-dessus de la fréquence de générateur (f_{G}).

4. Dispositif HF selon l'une des revendications précédentes, les propriétés capacitives et inductives du blindage (134) étant réglées de telle sorte qu'à la fréquence de générateur (f_{G}), il se forme dans le blindage (134) une onde électromagnétique stationnaire avec un noeud de courant au niveau de la fente (114).

5. Dispositif HF (100) selon l'une des revendications précédentes, la longueur de conduction électrique du blindage (134) correspondant pratiquement à un quart de la longueur d'onde λ de l'onde électromagnétique générée par le générateur.

6. Dispositif HF selon l'une des revendications 1 à 5, le dispositif résonant HF (110) étant exécuté en tant que guide d'ondes.

7. Dispositif HF selon l'une des revendications précédentes, le générateur (131) comprenant plusieurs modules de transistor (132) répartis le long de la périphérie du circuit résonant HF (110).

8. Dispositif HF selon la revendication 7, la fente étant limitée par deux brides (117, 118) de la paroi extérieure (111) du dispositif résonant HF (110) se faisant face et les modules de transistor (132) étant à chaque fois situés dans des évidements (124) à l'intérieur des deux brides (117, 118).

9. Accélérateur de particules (200) comprenant au moins un dispositif HF (100) selon l'une des revendications 1 à 8.

10. Accélérateur de particules (200) selon la revendication 9, l'accélérateur de particules (200) comprenant au moins deux cavités HF (100) montées l'une derrière l'autre.
